Europäisches Patentamt

**European Patent Office**

Office européen des brevets

(11) Veröffentlichungsnummer: **0 002 043**
**B1**

(12) # EUROPÄISCHE PATENTSCHRIFT

(45) Veröffentlichungstag der Patentschrift:
04.11.81

(51) Int. Cl.³: **G 03 C 5/00, G 03 F 7/08**

(21) Anmeldenummer. 78101352.9

(22) Anmeldetag: 11.11.78

(54) **Verfahren zum Herstellen eines Informationsträgers.**

(30) Priorität: 19.11.77 DE 2751741

(43) Veröffentlichungstag der Anmeldung:
30.05.79 Patentblatt 79/11

(45) Bekanntmachung des Hinweises auf die Patenterteilung:
04.11.81 Patentblatt 81/44

(84) Benannte Vertragsstaaten:
**BE DE FR GB NL**

(56) Entgegenhaltungen:
**DE-B-2 454 995**
**DE-B-2 657 246**
**DE-B-2 734 580**
**US-A-3 249 436**
**US-A-3 674 591**
**US-A-3 901 705**
**RESEARCH DISCLOSURE, Nr. 150,**
**Oktober 1976,**
**»Herstellung von Photolackpro-**
**filen«, Seite 49, Disclosure Nr.**
**15058**

(73) Patentinhaber: **HOECHST AKTIENGESELLSCHAFT,**
**Postfach 80 03 20, D-6230 Frankfurt/Main 80 (DE)**

(72) Erfinder: **Moraw, Roland, Dr., Buchenweg 4,**
**D-6200 Wiesbaden-Naurod (DE)**
Erfinder: **Schädlich, Renate, Erbsenacker 13,**
**D-6200 Wiesbaden-Naurod (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Verfahren zum Herstellen eines Informationsträgers

Die Erfindung betrifft ein Verfahren zum Herstellen eines Informationsträgers mit einer auf einem Träger aufgebrachten Aufzeichnungsschicht, die informationsmäßig belichtet und anschließend so entwickelt wird, daß sie in Bereichen der Oberfläche bildmäßig angeordnete statistische Strukturen aufweist, die das für die Projektion des Informationsträgers eingestrahlte Licht streuen.

Projektionsbilder mit intensitätsmoduliertem Licht durch Streuung zu erzeugen, ist bekannt.

Beim Vesikularfilm erfolgt die Lichtstreuung an Bläschen, die durch kombinierte Einwirkung von Licht und Wärme auf aromatische Diazoverbindungen in erweichbaren Schichten gebildet werden. Vesikularfilme sind im Gebrauch und ergeben in herkömmlichen Projektoren sehr kontrastreiche Bilder. Die Herstellung von Metallmatrizen von einem Vesikularfilm und damit die Duplizierung durch Prägen mit Hilfe der Metallmatrizen sind nicht möglich.

Bei Frostbildern in thermoplastischen Materialien erfolgt die Lichtstreuung an unregelmäßigen Oberflächenverformungen, die in den fotoleitenden, thermoplastischen Schichten durch elektrostatische Aufladung, bildmäßige Belichtung und Erwärmung gebildet werden.

Von Frostbildern ist eine praktische Anwendung nicht bekannt, was vermutlich darauf zurückzuführen ist, daß der Kontrast in herkömmlichen Projektoren nicht ausreicht.

Im Zuge der Ausweitung der Mikrofilmtechnik, insbesondere der Mikro-Publikation, bei der es sich um die Verbreitung neuer, bisher nicht veröffentlichter Informationen als Mikroform zum Verkauf und verlagsmäßigen Vertrieb in der Öffentlichkeit handelt, wird von modernen Aufzeichnungssystemen außer bestimmten sensitometrischen Eigenschaften auch eine leichte Duplizierbarkeit der Vorlagen zum Anfertigen einer großen Kopienzahl gewünscht. Eine dafür bevorzugte Technik ist das Prägen, wobei Oberflächenstrukturen mit einem Informationsgehalt durch Eindruck in ein prägbares Medium übertragen werden.

Es besteht ein Bedarf an einfach zu handhabenden Aufzeichnungsträgern, in denen die Information in Form von Oberflächenstrukturen aufgezeichnet ist, die durch Prägen vervielfältigt werden können und die ein Auslesen mit üblichen Projektoren ermöglichen.

Mit der aus der Zeitschrift Laser u. Opto-Elektronik, Nr. 3/1976, Seiten 16/17, bekannten ZOD (Zero-Order-Diffraction)-Technik werden gittermäßig gerasterte Bilder erzeugt. Von den Reliefbildern, die beispielsweise drei Grundfarbengittermustern in gelb, magenta und cyan in drei Fotolackschichten entsprechen, werden drei Nickelmatrizen hergestellt, mit denen farblose, thermoplastische Folien aus beispielsweise Polyvinylchlorid geprägt werden. Diese Folien werden mechanisch überlagert, und bei der Projektion mit konventionellen Projektoren werden von den farblosen Reliefbildern farbige Projektionsbilder erhalten. Die gitterförmige Rasterung erfolgt mit Reliefgittern von rechteckförmigem Querschnitt, wobei die Gitterperiode etwa 1,5 µm beträgt. Die gittermäßige Rasterung ist sowohl in bezug auf den Gitterabstand, d. h., die Dichte der Strukturen, als auch die Gittertiefe für eine bestimmte Farbe, d. h., die Amplitude der Information, periodisch. Für jeden Farbauszug in magenta, gelb und cyan werden getrennt je eine Nickelmatrize mit unterschiedlicher Relieftiefe erstellt, mit der die getrennten Prägebilder erzeugt werden. Die Relieftiefen sind unterschiedlich, wobei die Relieftiefe beim Cyanauszug am größten und beim Gelbauszug am kleinsten ist. Diese Farbauszugsbilder sind gerastert. Die Prägebilder werden zu einem dreischichtigen Reliefbild überlagert, von dem farbige Bilder projiziert werden können. Die beschriebene Technik ergibt sehr helle Farbbilder von großer Auflösung. Die Reliefbilder können durch Prägen relativ billig und schnell vervielfältigt werden.

Ein Nachteil, der die Einführung dieser Technik erschwert, ist der aufwendige Herstellungsprozeß mit drei vollständig getrennten Arbeitsgängen zur Herstellung der einzelnen, den Farbauszügen entsprechenden geprägten Reliefbilder. Ein weiterer Nachteil ist das paßgerechte Zusammensetzen der drei getrennten Reliefbilder zu dem für die farbige Projektion erforderlichen Duplikatbild.

Soll bei der ZOD-Technik im Projektionsbild neben anderen Farben auch die Farbe schwarz erhalten werden, so wird diese durch die mechanische Überlagerung der drei Folien, die den Farbauszügen für magenta, gelb, cyan entsprechen, erzeugt. Soll nur ein schwarz-weißes Bild erhalten werden, so werden an den schwarzen Bildstellen zwei sinusförmige Reliefgitter exakt vorgegebener Relieftiefe überkreuzt. Die Herstellung dieser Gitter erfordert große Präzision.

Die beiden US-Patentschriften 3 615 476 und 3 615 486 beschreiben Verfahren zur Aufzeichnung von Informationen in Polymeren oder Polymeren-Systemen, die photochemisch härtbar sind. Es wird eine direkt sichtbar zu machende Reproduktion eines elektromagnetischen Bildes als Schattenbild erhalten, indem die Aufzeichnungsschicht nach der Belichtung einer Wärme- und/oder Dampfbehandlung ausgesetzt wird, die zu einer Erweichung und Quellung der Aufzeichnungsschicht in den belichteten Bereichen führt, ohne daß es zu einer Abtragung kommt. Dabei überragen die belichteten die unbelichteten Bereiche deutlich und weisen Mikrodeformationen auf. In der Draufsicht sind die Deformationen infolge der Lichtstreuung direkt sichtbar. Wird die Aufzeichnungsschicht, die freitragend oder auf einem Träger aufgebracht sein kann, mit Licht durchstrahlt, so werden die belichteten Bereiche als ein Schattenbild aufgrund ihrer Streuwirkung sichtbar.

Aufgabe der Erfindung ist es, ein einfaches Verfahren zur Herstellung eines Informationsträgers zu schaffen, das es ermöglicht, nur durch Dosieren der eingestreuten Belichtungsenergie in der Aufzeichnungsschicht Strukturen zu erzeugen, die entweder ein positives oder ein negatives Projektionsstreubild der Vorlage liefern.

Diese Aufgabe wird dadurch gelöst, daß aktinisches Licht in informationsmäßiger Intensitätsverteilung und in statistisch unregelmäßig über den Bildbereich variierender Intensitätsverteilung eingestrahlt wird und daß anschließend die bestrahlten Bereiche durch ein Lösungsmittel gegenüber der ursprünglichen Dicke der Aufzeichnungsschicht abgetragen werden.

Die weitere Ausgestaltung des Verfahrens zur Herstellung des Informationsträgers ist den Patentansprüchen 2 bis 12 zu entnehmen.

Die Streubildtechnik hat den Vorteil, daß es durch einfaches Dosieren der Belichtungsenergie möglich ist, Strukturen im Fotolack entweder für ein positives oder ein negatives Projektionsbild einer vorgegebenen Vorlage zu erzeugen und eine überaus einfache und sichere Handhabung ermöglicht, da ohne Reliefgitter mit hoher Liniendichte, welche eine hochpräzise Herstellung erfordern, ausgekommen wird.

Die Erfindung wird im folgenden anhand der Zeichnungen näher erläutert. Es zeigt

Fig. 1 im Schnitt eine schematische Anordnung zur Belichtung eines Informationsträgers durch eine Vorlage,

Fig. 2 eine schematische Anordnung im Schnitt zur Belichtung eines weiteren Informationsträgers durch eine Vorlage,

Fig. 3 einen Informationsträger mit streuenden und beugenden Strukturen,

Fig. 4 einen Farbkeil mit veränderlicher Dichte der Streuzentren über die Länge des Farbkeils,

Fig. 5 und 6 den Zusammenhang zwischen der Dichte der Projektionsbilder und der Dichte der Vorlage,

Fig. 7 eine Anordnung zur Erzeugung von das Licht streuenden Oberflächenstrukturen im Fotolack,

Fig. 8 eine weitere Anordnung zur Erzeugung von das Licht streuenden Oberflächenstrukturen im Fotolack.

Zur Herstellung der streuenden Strukturen wird von einer Fotolackschicht ausgegangen. Wegen der Kleinheit der Streuzentren werden bevorzugt hochauflösende Fotolackschichten mit o-Chinondiaziden verwendet. Die Fotolackschicht ist zumindest 2 µm dick.

Die einfachste und daher für die Anwendung bevorzugte Methode ist die Kontaktbelichtung unter einer Schwarzbildauszugsfolie als Vorlage unter Bedingungen, die noch genauer angegeben werden.

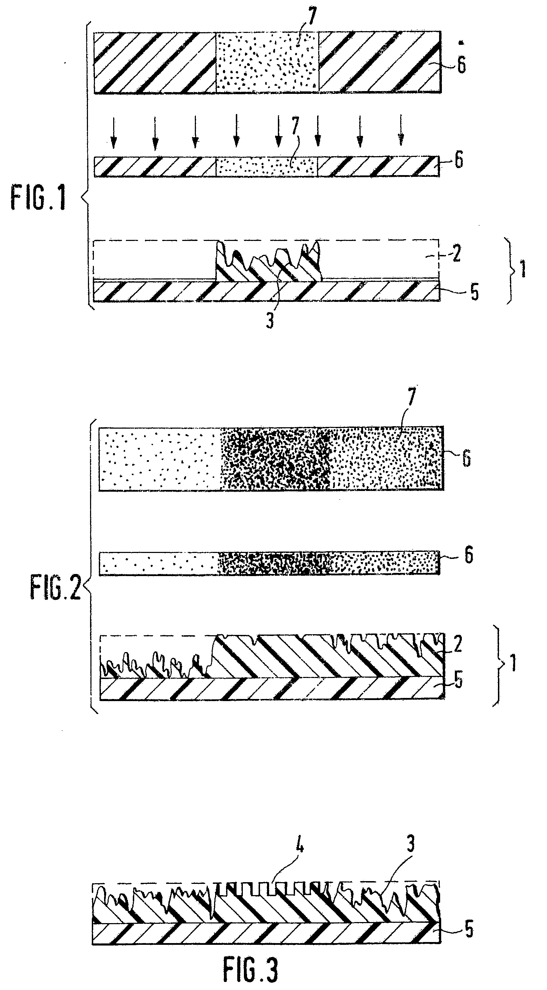

In Fig. 1 ist schematisch und im Schnitt eine Anordnung zur Belichtung eines Informationsträgers 1 durch eine derartige Vorlage 6 hindurch dargestellt. Auf der Vorlage 6 ist ein mittlerer Abschnitt mit einer alphanumerischen und/oder Bildinformation 7 belegt, die eine Vielzahl von lichtundurchlässigen Stellen aufweist, die durch Punkte angedeutet sind. Wird der in der Schnittansicht unter der Vorlage 6 befindliche Informationsträger 1 belichtet, der aus einer Trägerschicht und einer darauf aufgebrachten Aufzeichnungsschicht 2 in Form einer Fotolackschicht besteht, so durchstrahlt das Licht die links und rechts von der Bildinformation 7 liegenden Abschnitte der Vorlage 6, ohne daß eine informationsmäßige Intensitätsverteilung auf den entsprechenden Teilen der Aufzeichnungsschicht 2 erhalten wird.

Im mittleren Abschnitt mit der Bildinformation 7 werden die auftreffenden Lichtstrahlen, die durch Pfeile angedeutet sind, entsprechend der Anordnung der lichtundurchlässigen Stellen abgeschwächt bzw. gesperrt, so daß sich nach der Belichtung auf der Oberfläche der Aufzeichnungsschicht 2 des darunterliegenden Abschnitts des Informationsträgers 1 eine bild- bzw. informationsmäßige Intensitätsverteilung einstellt. Der derart belichtete Informationsträger 1 wird mit einer alkalischen wäßrigen Lösung behandelt, die die belichteten Teile herauslöst, so daß im mittleren Abschnitt eine Anordnung von Strukturen 3 erhalten wird, deren Verformungsgrad der Intensitätsverteilung auf der Oberfläche der Aufzeichnungsschicht 2 entspricht, während links und rechts vom mittleren Abschnitt die Aufzeichnungsschicht 2 nach der alkalischen Entwicklung weitgehend abgebaut ist. Diese Strukturen sind in bezug auf ihren gegenseitigen Abstand und ihre Tiefe unregelmäßig verteilt, mit anderen Worten, ihre Dichte und ihre Amplituden entsprechen einer statistischen, d. h. völlig unregelmäßigen Verteilung. Die vor der Entwicklung vorhandene Dicke der Aufzeichnungsschicht 2 ist gestrichelt eingezeichnet. In den Figuren ist die Dicke der Aufzeichnungsschicht 2 im Vergleich zum Träger 5 aus Gründen der Übersichtlichkeit stark vergrößert dargestellt. Bei praktischen Ausführungsbeispielen ist nämlich der Träger erheblich dicker als die Aufzeichnungsschicht.

An diesen Strukturen 3 wird das eingestrahlte Licht bei der Projektion des Informationsträgers 1 gestreut, so daß bei der Abbildung über eine Optik die streuenden Strukturen in der Projektion dunkel erscheinen.

Der von den Strukturen 3 bei der Projektion zu erzielende maximale Kontrast ist u. a. eine Funktion der benutzten Projektionsoptik. Je lichtschwächer diese Optik ist, desto größer ist der Kontrast. Ein praktikables System muß für gängige Projektionsoptiken mit einer Lichtstärke von etwa 1 : 2,8 geeignet sein, d. h., das gestreute Licht muß unter einem Winkel von 20° zur optischen Achse und darüber abgelenkt werden. Die das Licht streuenden Strukturen in der Aufzeichnungsschicht 2 müssen entspre-

chend angepaßt werden, um diese Bedingung zu erfüllen.

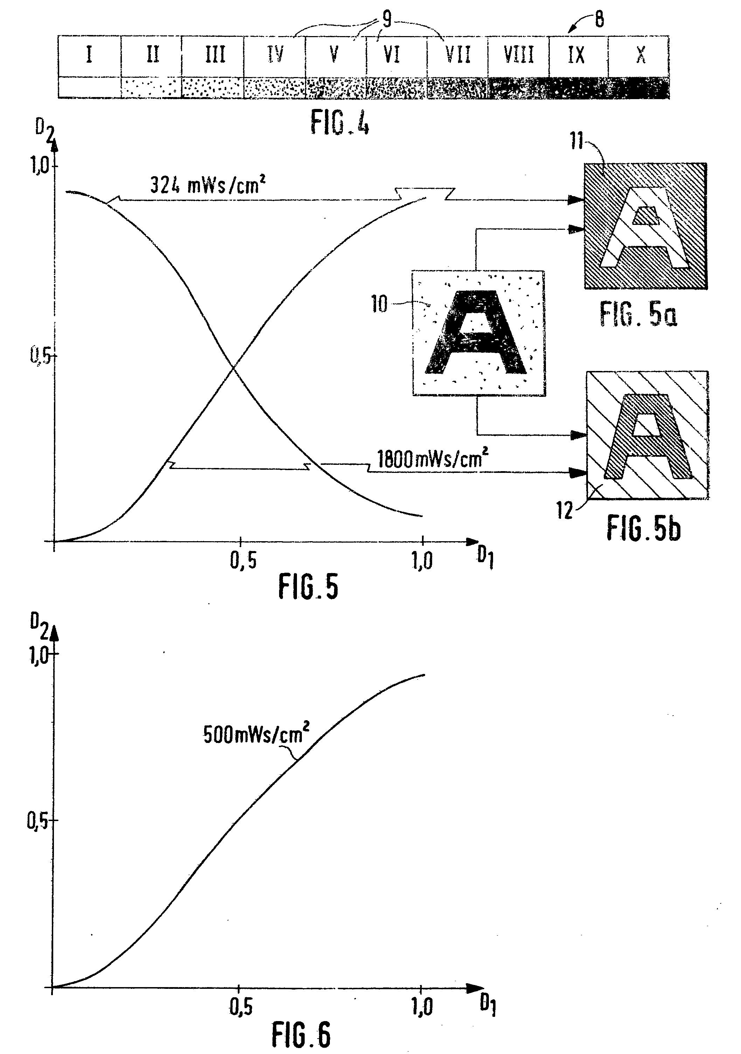

Die Streuwinkelbedingung ist unter folgenden Bedingungen leicht einzuhalten: Bei der Belichtung von Fotolacken, wie sie die Firma Siphley Comp. Inc., Newton, Mass., USA, vertreibt, mit aktinischem Licht von 400 nm durch eine Silberfilmvorlage hindurch, für die beispielsweise die Stufe II eines Farbtestkeils 8, wie er in Fig. 4 schematisch dargestellt ist, mit einer nominalen Dichte von 0,35 verwendet wird, und nachfolgender wäßrig-alkalischer Entwicklung und Projektion mit einer Optik der Lichtstärke 1 : 2,8 werden maximale Dichten von über eins erhalten. Solch ein Testkeil besteht aus stufenweise aufgegossenen, schwarz pigmentierten Schichten, die in Testkeilfeldern 9 mit von der Stufe I bis zur Stufe X ansteigender Dichte aufgebracht sind. Es ist selbstverständlich, daß so ein Testkeil auch weniger oder mehr als zehn Felder aufweisen kann und daß die Dichte von Stufe zu Stufe bei verschiedenen Fabrikaten unterschiedlich sein kann.

Die Dichte der Streuzentren in den einzelnen Stufen eines Testkeils steigt derart an, daß etwa ab der Stufe VII die Dichte so groß ist, daß nur noch einzelne Stellen frei von Streuzentren sind und Streulöcher bilden, während die übrigen Stellen der Stufe bei visueller Betrachtung einheitlich schwarz erscheinen. Nach dem Übergang von den Streuzentren zu den Streulöchern nimmt deren Zahl so ab, daß die Stufe X des Testkeils einheitlich schwarz erscheint, wie dies in Fig. 4 angedeutet ist.

Überraschenderweise werden praktisch dieselben Dichten auch dann erhalten, wenn bei der Belichtung zwischen der Fotolackschicht und der Streufolie transparente Abstandsfolien mit einer Dicke bis zu 15 μm angeordnet sind. Dies zeigt, daß bei der Kontaktbelichtung der Andruck bzw. der Abstand zwischen Aufzeichnungsschicht 2 und Streufolie unproblematisch ist. Der Farbton der Projektionsbilder ist ein farbneutrales Schwarz. Wird von der Oberflächenstruktur der Fotolackschicht eine Nickelmatrize abgenommen und damit eine thermoplastische Folie aus Polyvinylchlorid geprägt, so ergibt das Prägebild farbneutrale Projektionsbilder gleicher Dichte.

Vergleichbare Ergebnisse werden auch mit anderen bekannten Streufolien, die als Farbtestkeile mit mehreren Stufen ausgebildet sind, beispielsweise für die Stufe III, mit einer Nominaldichte von 0,45 erhalten.

Gemeinsame Kriterien für geeignete Streufolien für maximale Projektionsdichten sind, daß sie Streuzentren von etwa 1 μm Durchmesser mit einer Schwankungsbreite zwischen 0,5 und 2 μm Durchmesser enthalten, wobei die Streuzentren, projiziert auf die Oberfläche der Fotolackschicht, Abstände um 1,5 μm mit einer Schwankungsbreite zwischen 0,6 und 4 μm aufweisen sollen. Derartige Streufolien zeigen Transparenzen zwischen 0,25 und 0,65. Auch mit dichteren Streufolien können kontrastreiche Streubilder erzeugt werden, jedoch erst nach längeren Belichtungszeiten. Der Einsatz der Testkeile ermöglicht die Darstellung von Tonwertstufen in den Projektionsbildern.

Die beschriebene Streubildtechnik zeichnet sich bei guten sensitometrischen Ergebnissen durch eine überaus einfache und sichere Handhabung aus, was keineswegs trivial ist, da es bei bekannten Techniken erforderlich ist, durch mit großer Präzision hergestellte sinusförmige Reliefgitter von etwa 600 Linien/mm mit der als optimal angegebenen exakten Relieftiefe von 0,87 μm schwarz-weiße Projektionsbilder zu erzeugen (M. T. Gale, Opt. Comm. 18 [1976], 292).

Die gemeinsame informationsmäßige Belichtung und Streubelichtung durch eine Vorlage 6 hindurch wird anhand der in Fig. 2 schematisch dargestellten Anordnung zur Belichtung eines Informationsträgers 1 erklärt. Hierzu wird eine Schwarzbildauszugsfolie, z. B. eine Silberfilmvorlage des Originals, verwendet, die in einem Vorlage und Streufolie ist, wobei die Bildbereiche auf der Aufzeichnungsschicht 2, die den hellen Bereichen des Originals entsprechen, optisch dicht abgedeckt sind. Die Vorlage 6 weist beispielsweise im mittleren Abschnitt gemäß Fig. 2 nach der Belichtung und Entwicklung optische Dichten um 2 und darüber auf, entsprechend Transparenzen um 0,01 und weniger, während die links und rechts daran angrenzenden Abschnitte, die den schwarzen oder grauen Bildbereichen des Originals entsprechen, nur bis zu Transparenzen zwischen 0,25 und 0,65 für schwarz bzw. unter 0,25 für grau, wobei auch eine geringfügige Überlappung mit dem schwarzen Bereich noch möglich ist, anbelichtet sind.

Die Darstellung von Tonwertstufen kann auch durch allgemein bekannte Rastertechniken erfolgen.

Weiterhin kann die beschriebene Streubildtechnik sehr vorteilhaft mit der Technik der Farbbildwiedergabe von rechteckförmigen Reliefgittern unterschiedlicher Relieftiefen in einer Ebene kombiniert werden, wie dies in den deutschen Patentanmeldungen P 26 57 246.3 und P 27 34 580.8 beschrieben ist. Zur Aufzeichnung von Farbbildern mit schwarzen Bildelementen wird ein Schwarzauszugsbild überlagert. Dies gelingt in recht einfacher Weise, indem die Fotolackschicht durch eine Streufolie und eine Schwarzbildauszugsfolie derart belichtet wird, daß nur an den schwarzen Bildstellen Oberflächenstrukturen entstehen, die das Licht streuen. Diese Technik ist auch dann anwendbar, wenn zuvor die Fotolackschicht gitterförmig anbelichtet wurde.

In Fig. 3 ist ein Informationsträger 1 dargestellt, der im mittleren Bereich beugende Strukturen 4, die beispielsweise durch die Aufbelichtung eines Reliefgitters entstanden sind, enthält, während links und rechts von diesem Bereich streuende Strukturen 3 anschließen. In der Projektion erscheinen der mittlere Bereich farbig und die übrigen Bereiche dunkel.

In den Fig. 5 und 6 sind Dichtekennlinien dargestellt, die die Dichte $D_2$ des Projektionsbildes in Abhängigkeit von der Dichte $D_1$ der Bildinformation auf der Auszugsvorlage wiedergeben. Auf diese Dichtekennlinien wird in Zusammenhang mit den nachstehend angeführten Beispielen 1 und 3 nochmals eingegangen. Ein positives Projektionsbild wird erhalten, indem zuerst bildmäßig durch eine Auszugsvorlage mit der Dichte $D_1$ der Bildinformation belichtet und dann gleichmäßig durch eine Streufolie nachbelichtet wird. Ebenso kann die Reihenfolge dieser beiden Schritte vertauscht werden. Bei gleichzeitiger bild- bzw. informationsmäßiger Belichtung und Streubelichtung der Aufzeichnungsschicht wird wahlweise, entsprechend der Belichtungsdauer, ein negatives oder ein positives Projektionsbild erhalten.

Die Dichtekennlinien in Fig. 5 treten bei unterschiedlichen Belichtungsenergien auf. Auf der Ordinate ist die Dichte $D_2$ des Projektionsbildes aufgetragen, das unter Verwendung einer Optik der Lichtstärke 1 : 2,8, in Abhängigkeit von der Dichte $D_1$ der Streufolie, erstellt wird. Die Änderung der Dichte $D_1$ der Streufolie wird dabei mit einem Testkeil vorgenommen, dessen verschiedene Stufen der Reihe nach über einem jeweils neuen Informationsträger 1 während der Belichtung zu liegen kommen. Es wird bei einer eingestrahlten Energie von 324 mWs/cm² ein negatives Projektkionsbild der Auszugsvorlage und bei einer Energie von 1800 mWs/cm² ein positives Projektionsbild erhalten. Beim negativen Projektionsbild sind die Dunkel-Hell-Bereiche der Auszugsvorlage untereinander vertauscht, während dies bei einem positiven Projektionsbild nicht der Fall ist.

Es ist nicht erforderlich, daß die Streufolie selbst die Information enthält. Die Dichtekennlinie nach Fig. 6 wurde erhalten, indem zuerst bildmäßig durch die Auszugsvorlage hindurch belichtet und dann gleichmäßig durch die Stufe III eines bekannten Testkeils, der die Streufolie darstellte, nachbelichtet wurde.

Für qualitativ hochwertige Bilder, beispielsweise gerasterte mehrfarbige Bilder, wird von einer auf maximale Dichte des Streubildes optimal eingestellten Streufolie ausgegangen. Diese Streufolie kann ein anbelichteter entwickelter Silberfilm oder eine Pigmentschicht sein. Darauf wird ein für den kurzwelligen Spektralbereich undurchlässig eingefärbter Fotolack aufgebracht, der nur an den schwarzen Bildstellen entfernt wird. Auf die Streuschicht kann auch eine undurchlässige Metallschicht, beispielsweise aus Aluminium, aufgedampft werden, die mit Fotolack überschichtet wird. Durch bildmäßiges Belichten, Entwickeln und Ätzen werden die schwarzen Bildbereiche bis auf die Streuschicht freigelegt.

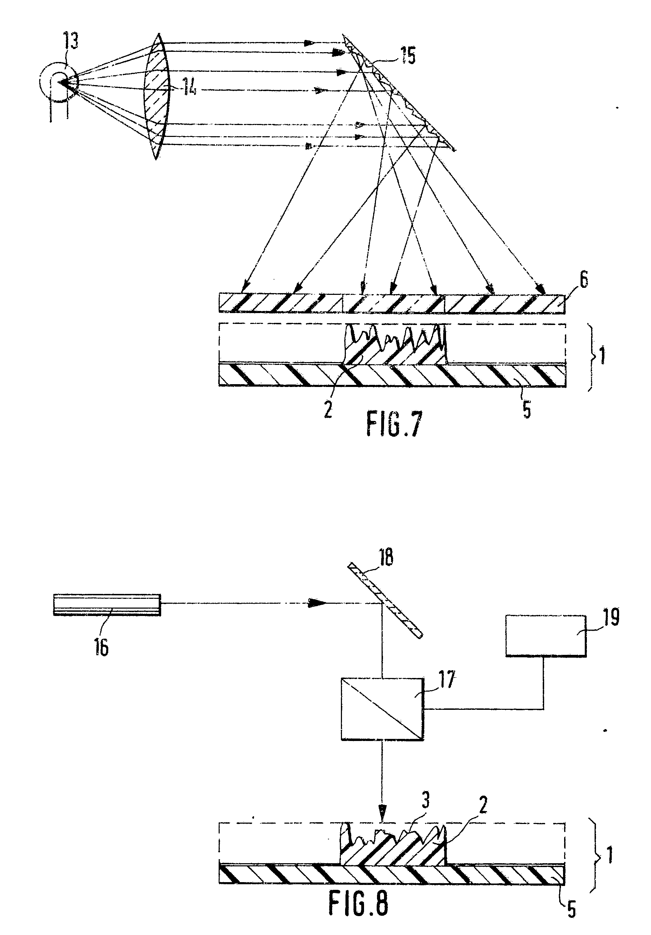

Zur Erzeugung der das Licht streuenden Oberflächenstrukturen in der Aufzeichnungsschicht kann auch die in Fig. 7 gezeigte Anordnung verwendet werden, bei der die Strahlen einer Lichtquelle 13 über eine Optik 14 auf einen Schirm 15 aus reflektierenden Teilchen wie Glassplitter auftreffen und von diesem Schirm auf die Aufzeichnungsschicht umgelenkt werden. Ebenso ist es möglich, einen perforierten Schirm mittels einer Lichtquelle auf die Aufzeichnungsschicht abzubilden.

In Fig. 8 ist eine Anordnung dargestellt, bei der die Strahlen eines Lasers 16, beispielsweise eines UV-Lasers, von einem Spiegel 18 in Richtung auf einen elektrooptischen Ablenker 17 umgelenkt werden, der durch einen Zufallsgenerator 19 gesteuert wird und entsprechend dessen Steuersignalen den Strahlengang hindurchläßt und in Richtung auf die Aufzeichnungsschicht des Informationsträgers 1 ablenkt.

### Beispiel 1

Eine 5 μm dicke Fotolackschicht ist auf einer 50 μm dicken Polyesterfolie als Träger aufgebracht und wird in einem Kopierrahmen unter einer Silberfilmvorlage 10 mit abgestuften Dichten belichtet.

In Fig. 5 ist die Silberfilmvorlage 10 dargestellt, auf der als Bildinformation der Buchstabe A aufgebracht ist. Wie schematisch angedeutet ist, entspricht die Dichte $D_1$ der Bildinformation der Silberfilmvorlage 10 einer der Stufen VII bis IX des Testkeils 8 nach Fig. 4 und enthält daher eine bestimmte Anzahl von Streulöchern. Die übrigen Bereiche der Silberfilmvorlage 10 entsprechen der Dichte eines der Streifen II bis IV des Testkeils 8.

Bei einem ersten Versuch werden 324 mWs/cm² auf die Fotolackschicht eingestrahlt, bei einem zweiten Versuch auf eine neue Fotolackschicht 1800 mWs/cm². Das aktinische Licht einer Quecksilberdampflampe wird hierzu durch eine Linse parallel gemacht und durch ein Blauglas mit einer maximalen Transmission bei der Wellenlänge von 400 nm hindurchgestrahlt. Anschließend wird wäßrig alkalisch entwickelt. Bei der Projektion mittels einer Optik mit der Lichtstärke 1 : 2,8 wird ein Projektionsbild mit in der Dichte abgestuften, farbneutralen Bereichen erhalten. Bei der eingestrahlten Energie von 324 mWs/cm² wird ein negatives Bild, bei der Energie von 1800 mWs/cm² ein positives Bild der Vorlage erhalten. Der eingestrahlten Energie von 324 mWs/cm² entspricht eine kurze Belichtungszeit, während der die Bildinformation A der Silberfilmvorlage 10 nur sehr wenig Licht durchläßt und an den Streuzentren in den übrigen Bereichen das Licht gestreut wird. Der entwickelte Informationsträger liefert dann ein Projektionsbild 11, das in Fig. 5a gezeigt ist und bei dem die Bildinformation hell und die übrigen Bereiche dunkel erscheinen, so daß das Projektionsbild ein Negativ der Silberfilmvorlage wiedergibt.

Bei der Belichtung mit 1800 mWs/cm², d. h., die Belichtungszeit ist etwa 5,6mal so groß wie im ersten Fall, werden die durch die Bildinformation abgedeckten Bereiche der Aufzeichnungsschicht des Informationsträgers nicht eingebrannt, sondern nur an den Stellen, die den Streulöchern gegenüberliegen, Strukturen in die Aufzeichnungsschicht eingebrannt, die in der Projektion Streuzentren bilden und dunkel erscheinen, wie dies in Fig. 5b angedeutet ist. Durch die lange Belichtungszeit werden die außerhalb der Bildinformation liegenden Bereiche des Informationsträgers, die den Streuzentren der Silberfilmvorlage zugeordnet sind, gleichfalls belichtet und dadurch die anfänglich gebildeten Strukturen eingeebnet, so daß das Projektionsbild ein Positiv 12 der Silberfilmvorlage 10 darstellt.

Zur Bestimmung der Dichten der Bilder werden mit einer Fotozelle die Intensitäten an verschiedenen Stellen der Projektionsbilder gemessen. Die daraus errechneten optischen Dichten der Projektionsbilder $D_2$ sind in Abhängigkeit von den angegebenen Dichten $D_1$ des verwendeten Testkeils in Fig. 5 dargestellt. Es werden maximale Werte um eins herum erreicht.

Die Reliefbilder in der Fotolackschicht werden mit einer dünnen Kupferschicht bedampft, auf der bis zu einer Schichtdicke von etwa 40 µm galvanisch Nickel abgeschieden wird, das eine Prägematrize ergibt. Mit dieser Matrize wird bei ca. 130°C in einer Presse eine Polyvinylchloridfolie geprägt. Die so gewonnenen Prägebilder zeigen in der Projektion gleichfalls in der Dichte abgestufte, farbneutrale Bereiche, die im Kontrast den Projektionsbildern des Original-Informationsträgers weitgehend gleichen.

### Beispiel 2

Die Bildaufzeichnung erfolgt unter den Bedingungen des Beispiels 1, wobei die Silberfilmvorlage das fotografische Negativ eines Landschaftsbildes darstellt. Nach kurzer Belichtung, d. h., mit einer Energie von 324 mWs/cm², und wäßriger alkalischer Entwicklung wird von der strukturierten Fotolackschicht ein tonwertrichtiges Bild der Landschaft projiziert.

### Beispiel 3

Eine 3 µm dicke Fotolackschicht auf einer 50 µm dicken Polyesterfolie als Träger wird durch einen kornlosen Stufenkeil mit 2 mm breiten Keilstufen mit 710 mWs/cm² bestrahlt. Der Stufenkeil besteht aus einer gelblich transparenten Folie mit einer optischen Dichte von 0,26 bei einer Wellenlänge von 400 nm, so daß durch eine, zwei, drei oder vier aufliegende Folien Dichten von 0,26/0,52/0,78/1,04 für diese Wellenlänge einstellbar sind. Anschließend wird ein Testkeil mit der Dichte 0,45 aufgelegt und Licht mit der Energie von 500 mWs/cm² eingestrahlt (Fig. 6). Nach der wäßrig alkalischen Entwicklung der Fotolackschicht ergibt die Projektion ein Bild mit nach der Dichte abgestuften, farbneutralen Bereichen. Aus den gemessenen Lichtintensitäten in den einzelnen Bereichen werden die optischen Dichten $D_2$ berechnet. Diese sind in Abhängigkeit von den Dichten $D_1$ des Testkeils in Fig. 4 dargestellt. Das Projektionsbild ist positiv, es werden Bildstellen großer Dichte des Originals durch Bildstellen großer Dichte im Projektionsbild wiedergegeben.

### Beispiel 4

Eine 3 µm dicke Fotolackschicht ist auf einem transparenten Träger aufgebracht und wird durch eine gerasterte, transparente Vorlage mit Licht der Energie von 150 mWs/cm² bestrahlt. Das Motiv auf der Vorlage ist mit einem 80er Raster, das ist ein Raster mit 80 Rasterelementen/cm, zerlegt. Anschließend wird nochmals Licht mit einer Energie von 150 mWs/cm² durch eine Streuvorlage, beispielsweise einen Testkeil, eingestrahlt. Nach der wäßrigen alkalischen Entwicklung gibt das Projektionsbild des Informationsträgers ebenso wie die Vorlage Halbtöne durch entsprechende dunkle Rasterpunkte wieder. Die optische Dichte im Zentrum eines Rasterpunktes beträgt 1,15.

### Beispiel 5

Eine 2,5 µm dicke Fotolackschicht wird durch Schleudern und Trocknen auf eine blanke transparente Polyesterfolie aufgebracht. Diese Schicht wird in Kontaktanordnung mit einem Gitter von 600 Linien/mm aus Metallstegen auf einer Glasplatte mit Licht der Energie von 250 mWs/cm² belichtet. Die Belichtungszeit ist auf die Projektionsfarbe grün abgestimmt. Anschließend wird unter paßgerecht aufgelegten Farbauszugsvorlagen belichtet, die nur an den Bildstellen der jeweiligen Farbauszugsvorlage und an den weißen Bildstellen transparent sind, wobei für rot/gelb/blau die eingestrahlte Lichtenergie 75/95/130 mWs/cm² beträgt. Als Schwarzauszugsvorlage ist ein Silberfilm vorgesehen, der an den hellen Bildstellen bis zur maximalen optischen Dichte und an den schwarzen Bildstellen bis zu einer optischen Dichte nach der Entwicklung von etwa 0,45 belichtet wurde. Die Belichtung mit der Schwarzauszugsvorlage erfolgt mit einer Lichtenergie von 300 mWs/cm². Nach der wäßrigen alkalischen Entwicklung liefert die strukturierte Fotolackschicht ein farbiges Projektionsbild, das die schwarzen Bildstellen mit einer optisch farbneutralen Dichte von 0,95 wiedergibt. Die Projektionsfarben entsprechen nicht ganz dem farbigen Originalbild, weil die Belichtungszeiten bei den Farbauszugsbelichtungen auf den Unterschied des Brechungsindizes von Fotolack und Prägefolie korrigiert sind. Das Reliefbild wird mit einer dünnen Kupferschicht bedampft und darauf bis zu einer Schichtdicke von etwa 40 µm galvanisch Nickel abgeschieden. Die so erzeugte Metallmatrize wird von der Fotolackschicht getrennt und damit bei ca. 130°C in einer Presse eine glasklare Polyvinylchloridfolie geprägt. Das erhaltene Prägebild zeigt ein dem farbigen Originalbild entsprechendes farbiges Projektionsbild mit dunklen Bildstellen, die den schwarzen Bildstellen des Originals entsprechen.

**Patentansprüche**

1. Verfahren zum Herstellen eines Informationsträgers mit einer auf einem Träger aufgebrachten Aufzeichnungsschicht, die informationsmäßig belichtet und anschließend so entwickelt wird, daß sie in Bereichen der Oberfläche bildmäßig angeordnete statistische Strukturen aufweist, die das für die Projektion des Informationsträgers eingestrahlte Licht streuen, dadurch gekennzeichnet, daß aktinisches Licht in informationsmäßiger Intensitätsverteilung und in statistisch unregelmäßig über den Bildbereich variierender Intensitätsverteilung eingestrahlt wird und daß anschließend die bestrahlten Bereiche durch ein Lösungsmittel gegenüber der ursprünglichen Dicke der Aufzeichnungsschicht abgetragen werden.

2. Verfahren nach Anspruch 1, dadurch gekennzeichnet, daß die Belichtung mit informationsmäßiger Intensitätsverteilung und die Belichtung mit statistisch unregelmäßiger Intensitätsverteilung gleichzeitig erfolgen.

3. Verfahren nach Anspruch 1, dadurch gekennzeichnet, daß zuerst die Belichtung mit informationsmäßiger Intensitätsverteilung und anschließend die Belichtung mit statistisch unregelmäßiger Intensitätsverteilung erfolgt.

4. Verfahren nach Anspruch 1, dadurch gekennzeichnet, daß zuerst die Belichtung mit statistisch unregelmäßiger Intensitätsverteilung und dann die Belichtung mit informationsmäßiger Intensitätsverteilung erfolgt.

5. Verfahren nach den Ansprüchen 1 bis 4, dadurch gekennzeichnet, daß nur bestimmte Bereiche der gesamten Aufzeichnungsfläche mit statistisch unregelmäßiger Intensitätsverteilung belichtet werden.

6. Verfahren nach den Ansprüchen 1 bis 5, dadurch gekennzeichnet, daß der Belichtung mit statistisch unregelmäßiger Intensitätsverteilung eine Belichtung mit gitterförmiger Intensitätsverteilung überlagert wird.

7. Verfahren nach den Ansprüchen 2 bis 6, dadurch gekennzeichnet, daß die informationsmäßige Intensitätsverteilung rasterförmig moduliert wird.

8. Verfahren nach den Ansprüchen 2 bis 7, dadurch gekennzeichnet, daß die Belichtung mit statistisch unregelmäßiger Intensitätsverteilung durch eine Streuvorlage hindurch erfolgt.

9. Verfahren nach den Ansprüchen 2 bis 8, dadurch gekennzeichnet, daß die Belichtung mit statistisch unregelmäßiger Intensitätsverteilung im Kontakt mit einer Streuvorlage erfolgt.

10. Verfahren nach den Ansprüchen 2 bis 9, dadurch gekennzeichnet, daß die Belichtung mit statistisch unregelmäßiger Intensitätsverteilung durch eine Streuvorlage erfolgt, die Streuzentren mit Durchmessern von 0,5 μm bis 2 μm mit Abständen zwischen 0,6 μm und 4 μm enthält.

11. Verfahren nach Anspruch 1, dadurch gekennzeichnet, daß die Einstrahlung von aktinischem Licht mit statistisch unregelmäßig variierender Intensitätsverteilung durch Abbilden eines Schirms aus reflektierenden Teilchen über eine Optik auf die Aufzeichnungsschicht durchgeführt wird.

12. Verfahren nach Anspruch 1, dadurch gekennzeichnet, daß eine statistisch unregelmäßig variierende Intensitätsverteilung durch Einstrahlen von UV-Laserlicht auf die Aufzeichnungsschicht über einen durch einen Zufallsgenerator gesteuerten Ablenker erzeugt wird.

**Claims**

1. Process for the manufacture of an information carrier comprising a recording layer disposed on a support, said recording layer being information-wise exposed and then developed in a manner that in areas of its surface image-wise arranged statistically distributed structures are provided which scatter the light irradiated for the projection of the information carrier, characterized in that actinic light is irradiated in an information-wise distribution of intensity and in a statistical distribution of intensity irregularly varying over the image area and in that subsequently the irradiated areas are reduced in their thickness by means of a solvent as compared with the original thickness of the recording layer.

2. Process according to claim 1, characterized in that the exposure to light of an information-wise distribution of intensity and the exposure to light of a statistical, irregular distribution of intensity are simultaneously effected.

3. Process according to claim 1, characterized in that the material is first exposed to light of an information-wise distribution of intensity and then to light of a statistical, irregular distribution of intensity.

4. Process according to claim 1, characterized in that the material is first exposed to light of a statistical, irregular distribution of intensity and then to light of an information-wise distribution of intensity.

5. Process according to claims 1 to 4, characterized in that only selected areas of the entire recording surface are exposed to light of statistical, irregular distribution of intensity.

6. Process according to claims 1 to 5, characterized in that an exposure to light of a grating-like distribution of intensity is superimposed upon the exposure to light of a statistical, irregular distribution of intensity.

7. Process according to claims 2 to 6, characterized in that the information-wise distribution of intensity is subjected to grating-like modulation.

8. Process according to claims 2 to 7, characterized in that the material is exposed to light of a statistical, irregular distribution of intensity through a light-scattering original.

9. Process according to claims 2 to 8, characterized in that the material is exposed to light of a statistical, irregular distribution of intensity while it is in contact with a light-scattering original.

10. Process according to claims 2 to 9, characterized in that the material is exposed to light of a statistical, irregular distribution of intensity through a light-scattering original which comprises scattering centers with diameters of 0.5 to 2 µm spaced from each other by distances of 0.6 to 4 µm.

11. Process according to claim 1, characterized in that irradiation with actinic light of a statistical, irregularly varying distribution of intensity is effected by reproducing a screen of reflecting particles by means of a lens on the recording layer.

12. Process according to claim 1, characterized in that a statistical, irregularly varying distribution of intensity is achieved by irradiating the recording layer with UV laser light over a deflector which is controlled by a random pulse generator.

## Revendications

1. Procédé de fabrication d'un porteur d'information comportant une couche d'enregistrement qui est appliquée sur un support et qui est insolée en fonction des informations avant d'être développée de manière qu'elle présente, dans les zones appropriées de sa surface, des déformations statistiques qui correspondent à l'image et qui assurent la dispersion de la lumière incidente nécessaire à la projection du porteur d'informations, ce procédé étant caractérisé en ce que l'intensité d'une lumière actinique incidente est répartie en fonction de l'information, d'une part, et d'une manière statistiquement irrégulière sur l'ensemble de la partie couverte par l'image, d'autre part, et en ce que les zones ainsi insolées sont finalement réduites par rapport à l'épaisseur initiale de la couche d'enregistrement à l'aide d'un solvant approprié.

2. Procédé selon la revendication 1, caractérisé en ce que l'insolation avec répartition de l'intensité en fonction de l'information et l'insolation avec une répartition de l'intensité statistiquement irrégulière s'effectuent simultanément.

3. Procédé selon la revendication 1, caractérisé en ce que l'on procède d'abord à l'insolation avec répartition de l'intensité en fonction de l'information et ensuite à l'insolation avec une répartition statistiquement irrégulière de l'intensité.

4. Procédé selon la revendication 1, caractérisé en ce que l'on procède d'abord à l'insolation avec une répartition statistiquement irrégulière de l'intensité et ensuite à l'insolation avec répartition de l'intensité en fonction de l'information.

5. Procédé selon les revendications 1 à 4, caractérisé en ce que seules quelques zones, déterminées sur l'ensemble de la surface d'enregistrement, sont insolées avec une répartition statistiquement irrégulière de l'intensité.

6. Procédé selon les revendications 1 à 5, caractérisé en ce que l'insolation avec une répartition statistiquement irrégulière de l'intensité est doublée d'une insolation avec répartition de l'intensité en forme d'une grille.

7. Procédé selon les revendications 2 à 6, caractérisé en ce que la répartition de l'intensité en fonction de l'information est modulée compte tenu de la form de la trame.

8. Procédé selon les revendications 2 à 7, caractérisé en ce que l'insolation avec une répartition statistiquement irrégulière de l'intensité s'effectue à travers un élément dispersif.

9. Procédé selon les revendications 2 à 8, caractérisé en ce que l'insolation avec une répartition statistiquement irrégulière de l'intensité s'effectue au contact avec un élément dispersif.

10. Procédé selon les revendications 2 à 9, caractérisé en ce que l'insolation avec une répartition statistiquement irrégulière de l'intensité s'effectue à travers un élément dispersif comportant des points de dispersion dont le diamètre varie entre 0,5 µm et 2 µm et qui sont espacés de 0,6 µm à 4 µm.

11. Procédé selon la revendication 1, caractérisé en ce que l'insolation par la lumière actinique, avec répartition statistiquement irrégulière de l'intensité, est assurée par la reproduction d'un écran composé de particules réfléchissantes, par l'intermédiaire d'un dispositif optique, sur la couche d'enregistrement.

12. Procédé selon la revendication 1, caractérisé en ce qu'une répartition de l'intensité, variant statistiquement irrégulièrement est obtenue à l'aide de la lumière qui est émise par un laser à rayons ultra-violets et qui est dirigée sur la couche d'enregistrement par l'intermédiaire d'un réflecteur commandé par un générateur de hasards.

FIG.1

FIG.2

FIG.3

FIG.4

324 mWs/cm²

1800 mWs/cm²

FIG.5

FIG. 5a

FIG.5b

500mWs/cm²

FIG.6

FIG.7

FIG.8